(19) Europäisches Patentamt
European Patent Office
Office européen des brevets

(11) EP 4 768 977 A1

(12) EUROPEAN PATENT APPLICATION

(43) Date of publication:
**01.07.2026 Bulletin 2026/27**

(21) Application number: **24472020.7**

(22) Date of filing: **27.12.2024**

(51) International Patent Classification (IPC):
***G01R 33/00** (2006.01)* ***G01D 3/036** (2006.01)*

(52) Cooperative Patent Classification (CPC):
**G01D 3/036; G01R 33/0029; G01R 33/07**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **Melexis Bulgaria EOOD**
**1138 Sofia (BG)**

(72) Inventor: **Marinov, Tsvetan**
**1138 Sofia (BG)**

(74) Representative: **Kay, Ross Marcel**
**Laudens**
**Blackwell House**
**Guildhall Yard**
**London EC2V 5AE (GB)**

Remarks:
Amended claims in accordance with Rule 137(2) EPC.

(54) **SENSOR OUTPUT SIGNAL PROCESSING CIRCUIT APPARATUS AND METHOD OF DIAGNOSTIC SIGNAL GENERATION AND EXTRACTION**

(57) An apparatus comprises a sensor readout circuit (110, 134) receiving a conditioned analogue sensor signal (106, 108) comprising a measurement offset and having a first cycle of a first duration (501). A diagnostic signal circuit (116) comprises a signal generator (204) coupled to an amplitude modulator (202) to modulate an analogue diagnostic signal (504) from the signal generator. The sensor readout circuit amplifies and combines the sensor and modulated diagnostic signals (504) to provide a digital output signal (138) comprising representations of: the combination of the amplified sensor signal and the amplified modulated diagnostic signal, an amplification offset, and the measurement offset. A signal extractor (136) processes the digital output signal and provides separately offset-less digital representations of the amplified sensor signal and the diagnostic signal in amplified form. The amplitude modulator alternates polarities of the diagnostic signal so that the modulated diagnostic signal has a second cycle of a second duration (518) that is an even numbered multiple of the first duration.

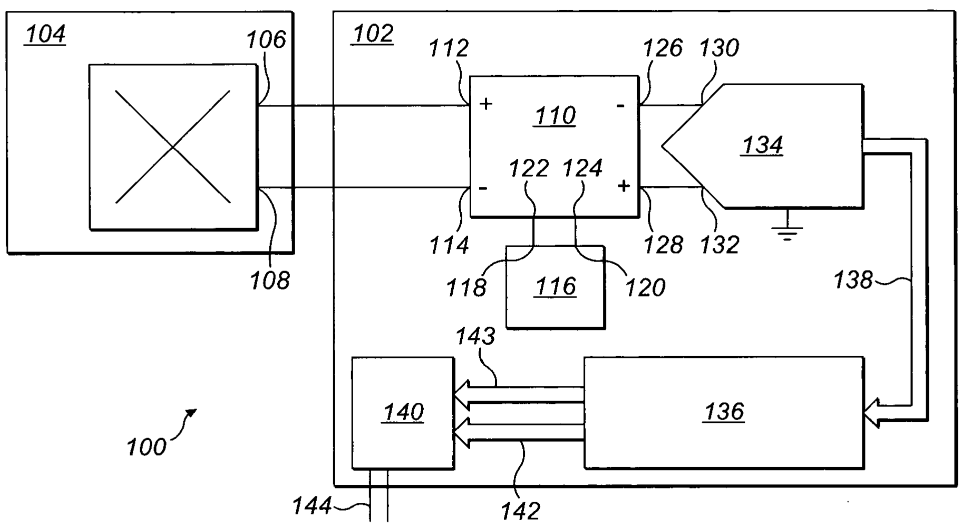


FIG. 1



Processed by Luminess, 75001 PARIS (FR)

## Description

The present invention relates to a sensor output signal processing circuit apparatus of the type that, for example, generates a diagnostic signal and combines the diagnostic signal with a conditioned analogue sensor signal. The present invention also relates to a method of diagnostic signal generation and extraction, the method being of the type that, for example, comprises generating a diagnostic signal and combining the diagnostic signal with a conditioned analogue sensor signal.

In the field of semiconductor sensors, it is known to operably couple a semiconductor sensor to a readout circuit, which is typically part of a larger integrated circuit used to process analogue electrical output signals generated by the semiconductor sensor. The readout circuit usually comprises an amplifier stage or stages to amplify, in many cases, a small sensor signal to yield a larger signal before it is further processed, for example converted to the digital domain. The amplifier or amplifiers have an offset, which is then also amplified, leading to an unwanted error being introduced into the output signal of the amplifier stage. To solve this problem, a so-called chopping technique is implemented in the readout circuit. Using the chopping technique, an input signal to the amplifier stage(s) is modulated with a square wave and demodulated after the amplifier stage(s). With magnetic sensors, for example Hall sensors, similar offset cancellation of the sensor signal can be achieved by using a so-called spinning technique, which can be performed in, for example, two phases or four phases. The two-phase system is similar to chopping and four phase system differs from the chopping only by how the sensor output is calculated after demodulation.

Furthermore, it is known for Hall elements to have an offset which arises from process- and geometry-related variations. This can be notionally modelled using a resistor bridge analogy where the offset of the Hall sensor can be represented as an imbalance of the resistor bridge. The imbalance can be compensated by switching the diagonals of the resistor bridge used for biasing and readout, which is analogous to the spinning technique mentioned above. The offset can be effectively minimised using this technique, examples of which can be found, for example, in International patent publication no. WO 01/18556 A1, EP-A1-0 548 391, and DE-A1-43 02 342.

Typically, the integrated circuit comprises on-chip diagnostic functionality in order to monitor and diagnose different parts of the semiconductor device. Such diagnostic functionality can include feeding a part of the integrated circuit under test with a constant value voltage or current, and the response is measured as a single value after analogue-to-digital conversion. However, this kind of diagnostic testing does not directly test the performance of a signal processing chain comprising the readout circuit and analogue-to digital conversion circuitry.

Such diagnostic functionality usually requires the diagnostic signal to be continuously evaluated. A typical approach is to provide a secondary analogue-to-digital converter, smaller than a primary analogue-to-digital converter used to digitise the analogue electrical output signals generated by the semiconductor sensor, dedicated to processing of the diagnostic signal. This approach requires additional die space and materials and so increases the overall cost of the sensor device. Other techniques include providing a multiplexer to multiplex the diagnostic signal with the analogue electrical output signals. However, this approach jeopardises bandwidth and jitter characteristics of the sensor device.

According to a first aspect of the present invention, there is provided a sensor output signal processing circuit apparatus comprising: a sensor readout circuit configured to receive, when in use, a conditioned analogue sensor signal comprising a measurement offset and having a first cycle of a first duration; a diagnostic signal circuit comprising an amplitude modulator circuit and a signal generator circuit operably coupled to the amplitude modulator circuit, the signal generator circuit being configured to generate, when in use, an analogue diagnostic signal and the amplitude modulator circuit being configured to modulate the analogue diagnostic signal to provide a modulated analogue diagnostic signal to the sensor readout circuit; and a signal extraction circuit operably coupled to a digital output of the sensor readout circuit; wherein the sensor readout circuit is configured to amplify and combine the conditioned analogue sensor signal and the modulated analogue diagnostic signal and to provide at the digital output thereof a digital output signal comprising a digital representation of the combination of the amplified analogue conditioned sensor signal and the amplified modulated analogue diagnostic signal, a digital representation of an amplification offset, and a digital representation of the measurement offset; the signal extraction circuit is configured to digitally process, when in use, the digital output signal and to provide separately digital demodulated representations of the amplified conditioned analogue sensor signal and the analogue diagnostic signal in amplified form, both without the measurement and amplification offsets; and the amplitude modulator circuit is configured to alternate polarities of the analogue diagnostic signal so that the modulated analogue diagnostic signal has a second cycle of a second duration where the second duration is an even numbered multiple of the first duration.

The modulated analogue diagnostic signal may be phase aligned with the conditioned analogue sensor signal.

The first cycle may comprise a plurality of consecutive pulse durations respectively corresponding to a plurality of pulses of the conditioned analogue sensor signal.

The conditioned analogue sensor signal may have a rectangular waveform.

The consecutive pulse durations may be of equal duration.

The plurality of pulses may respectively result from application, when in use, of a spinning signal to an output signal generated by a magnetic sensor.

The magnetic sensor may be a Hall sensor.

The sensor readout circuit may comprise a summing amplifier circuit operably coupled to an analogue-to-digital converter circuit having the digital output; the summing amplifier circuit may be configured to receive, when in use, the conditioned analogue sensor signal.

An output of the diagnostic signal circuit may be operably coupled to an input of the summing amplifier circuit.

The signal extraction circuit may comprise a first shift register and a first summation circuit operably coupled to the first summation circuit; the signal extraction circuit may be configured to process, when in use, discrete temporal portions of a cycle of a waveform of the digital output signal in order to attenuate the amplification and measurement offsets in the digital output signal and provide the demodulated digital representation of the amplified conditioned analogue sensor signal.

The signal extraction circuit may comprise a second shift register and a second summation circuit operably coupled to the second summation circuit and may be configured to process, when in use, discrete temporal portions of a cycle of a waveform of the digital output signal in order to attenuate the amplification and measurement offsets in the digital output signal and provide the digital representation of the analogue diagnostic signal in amplified form.

Each discrete temporal portion of the cycle of the waveform of the digital output signal may have substantially the same duration as a pulse of the plurality of pulses of the first cycle of the conditioned analogue sensor signal.

The apparatus may further comprise: a signal analysis circuit configured to analyse the digital representation of the analogue diagnostic signal in amplified form in order to monitor one or more of: a voltage proportional to a temperature of a die comprising the sensor output signal processing circuit; a reference voltage level used to generate the digital output signal; a voltage drop across a diagnostic shunt resistor configured to receive a bias current for a Hall sensor; and a gain of an amplification path of the sensor readout circuit.

According to a second aspect of the present invention, there is provided a magnetic field measurement apparatus comprising: a Hall sensor having a readout output; and a signal conditioning circuit operably coupled to the Hall sensor; wherein the readout output of the Hall sensor is operably coupled to an analogue input of the sensor readout circuit of the sensor output signal processing circuit apparatus as set forth above in relation to the first aspect of the invention.

The conditioned analogue sensor signal may have a greater frequency than the modulated analogue diagnostic signal.

The amplitude modulator circuit may be a chopping circuit.

The conditioned analogue sensor signal may have a first frequency associated therewith; the modulated analogue diagnostic signal may have a second frequency associated therewith; and the first frequency may be twice the second frequency.

The conditioned analogue sensor signal may have a first frequency associated therewith; the modulated analogue diagnostic signal may have a second frequency associated therewith; and the first frequency may be between 100 to 1000 times faster than the second frequency.

According to a third aspect of the present invention, there is provided a method of diagnostic signal generation and extraction, the method comprising: receiving a conditioned analogue sensor signal comprising a measurement offset and having a first cycle of a first duration; generating an analogue diagnostic signal and modulating the analogue diagnostic signal to provide a modulated analogue diagnostic signal; amplifying and combining the conditioned analogue sensor signal and the modulated analogue diagnostic signal; generating a digital output signal from the combination of the amplified conditioned analogue sensor signal and the amplified modulated diagnostic signal, the digital output signal comprising a digital representation of the combination of the amplified analogue conditioned sensor signal and the amplified modulated analogue diagnostic signal, a digital representation of an amplification offset and a digital representation of the measurement offset; and digitally processing the digital output signal in order to provide separately demodulated digital representations of the amplified conditioned analogue sensor signal and the analogue diagnostic signal in amplified form, both without the measurement and amplification offsets; wherein the modulating of the analogue diagnostic signal comprises alternating polarities of the analogue diagnostic signal so that the modulated analogue diagnostic signal has a second cycle of a second duration where the second duration is an even numbered multiple of the first duration.

It is thus possible to provide an apparatus and method that provides diagnostic capabilities in relation to the signal processing chain and circuitry peripheral to the signal processing chain without additional complexity and cost, while also preserving bandwidth and jitter characteristics of a sensor device.

At least one embodiment of the invention will now be described, by way of example only, with reference to the accompanying drawings, in which:

**Figure 1** is a schematic block diagram of a sensor output signal processing circuit apparatus constituting an embodiment of the invention;

**Figure 2** is a schematic diagram of part of the sensor output signal processing circuit apparatus of Figure 1 in greater detail;

**Figure 3** is a schematic diagram of a summing amplifier of Figure 2 in greater detail;

**Figure 4** is a schematic diagram of a signal extraction circuit of the sensor output signal processing circuit of Figure 1 in greater detail;

**Figure 5** is a flow diagram of a method of diagnostic signal generation and extraction constituting a further embodiment of the invention;

**Figure 6** is a schematic diagram comparing a conditioned analogue sensor signal with a modulated analogue diagnostic signal generated by the sensor output signal processing circuit apparatus of Figure 1; and

**Figure** 7 is a diagram of the combination of the amplified conditioned analogue sensor signal and the amplified modulated analogue diagnostic signal.

Throughout the following description, identical reference numerals will be used to identify like parts.

Referring to Figure 1, a magnetic sensor device 100 comprises a sensor output signal processing circuit 102 operably coupled to a magnetic sensor 104, for example a Hall sensor, having a first output 106 and a second output 108 providing a differential output. In this example, the magnetic sensor 104 comprises a signal conditioning circuit (not shown). However, in other examples, the signal conditioning circuit can be provided independently of the magnetic sensor 104, i.e. separate from the magnetic sensor 104, and the output terminals 106, 108 of the magnetic sensor 104 can be coupled to the sensor output signal processing circuit 102 via the signal conditioning circuit. As will be explained later herein, the magnetic sensor 104 generates a "conditioned" analogue sensor signal, for example through application of a so-called spinning signal, constituting a conditioning signal, to the Hall sensor by the signal conditioning circuit mentioned above that is operably coupled to the Hall sensor. In this regard, a known conditioning process is applied during the operation of the magnetic sensor 104 owing to the magnetic sensor 104 having a known measurement offset that needs to be removed or mitigated in relation to a final measurement of a magnetic field.

The sensor output signal processing circuit 102 comprises a readout circuit, the readout circuit comprising a signal combination circuit, for example a summing amplifier circuit 110, having first and second inputs 112, 114 respectively coupled to the first and second outputs 106, 108 of the magnetic sensor 104. In this example, the first and second outputs 106, 108 constitute a readout output of the magnetic sensor 104. As mentioned above, in some examples, the signal conditioning circuit is separate from the magnetic sensor 104 and not packaged with the magnetic sensor 104. The readout circuit also comprises an Analogue-to-Digital Converted (ADC) circuit 134 operably coupled to the summing amplifier circuit 110.

The sensor output signal processing circuit 102 also comprises a diagnostic signal circuit 116 having first and second outputs 118, 120 that are operably coupled to third and fourth inputs 122, 124 of the summing amplifier circuit 110. First and second outputs 126, 128 of the summing amplifier circuit 110 are respectively coupled to first and second inputs 130, 132 of the ADC circuit 134.

A digital output of the ADC circuit 134, and hence in this example the sensor readout circuit, is operably coupled to a signal extraction circuit 136 of the sensor output signal processing circuit 102 by a first data bus 138. The signal extraction circuit 136 is operably coupled to a signal analysis circuit 140 of the sensor output signal processing circuit 102 by a sensor signal data bus 142 and a diagnostic signal data bus 143, the signal analysis circuit 140 having an analysis output 144.

Turning to Figure 2, the first and second inputs 112, 114 of the summing amplifier circuit 110 are operably coupled to the signal conditioning circuit 200 of the magnetic sensor 104. The conditioning circuit 200 is shown schematically as a chopping circuit to facilitate understanding, though the skilled person will appreciate that the conditioning circuit 200 is not, in practice, coupled to an output of the magnetic sensing element of the magnetic sensor 104. The third and fourth inputs 122, 124 of the summing amplifier circuit 110 are operably coupled to a chopping circuit 202 of the diagnostic signal circuit 116; the chopping circuit 202 serves as an amplitude modulator circuit. In this example, the diagnostic signal circuit 116 comprises a differential DC signal generator circuit 204 operably coupled to the chopping circuit 202. However, in other examples, a multiplexer can be operably coupled to the chopping circuit 202, and a plurality of differential DC signal generators can be provided, coupled to inputs of the multiplexer, so that different differential DC signal generators can be switched to the chopping circuit 202 as desired. As described above in relation to Figure 1, the first and second outputs 126, 128 of the summing amplifier circuit 110 are respectively coupled to the first and second inputs 130, 132 of the ADC circuit 134.

In this example, the signal conditioning circuit 200 of the magnetic sensor 104 has a notional first switching input 206 for switching the signal conditioning circuit 200 at a first switching frequency, $f_1$. The chopping circuit 202 comprises a second switching input 208 for switching the chopping circuit 202 at a second frequency, $f_2$. The ADC circuit 134 also comprises a third input 210 for controlling sampling by the ADC 134 at a frequency greater than the first frequency, $f_1$, for example twice the first frequency, $f_1$, and maintaining phase alignment with the clocking signal providing the first frequency, $f_1$. In this regard, the ADC 134 is more generally clocked so as to sample in each phase of the clocking signal providing the first switching frequency, $f_1$, to the signal conditioning circuit 200.

Referring to Figure 3, the summing amplifier circuit 110 comprises a first amplifier 220 and a second amplifier 222. An inverting input of the first amplifier 220 is operably coupled to the first input 112 of the summing amplifier circuit 110 via a first input resistor 224, and an inverting input of the second amplifier 222 is operably coupled to the second input 114 of the summing amplifier circuit 110 via a second input resistor 226. Hence, inverting inputs of the first and second amplifiers 220, 222 are respectively operably coupled to the first and second output terminals 106, 108 of the magnetic sensor 104 via the first and second input resistors 224, 226. The inverting input of the first amplifier 220 is also operably coupled to the third input 122 of the summing amplifier circuit 110 via a third input resistor 228, and the inverting input of the second amplifier 222 is operably coupled to the fourth input 124 of the summing amplifier circuit 110 via a fourth input resistor 230. Hence, inverting inputs of the first and second amplifiers 220, 222 are also respectively operably coupled to the first and second output terminals 118, 120 of the diagnostic signal circuit 116 via the third and fourth input resistors 228, 230. Non-inverting inputs of the first and second amplifiers 220, 222 are coupled to a common-mode voltage source (not shown), $V_{CM}$.

An output of the first amplifier 220 is operably coupled to the inverting input of the first amplifier 220 via a first feedback resistor 232, and an output of the second amplifier 222 is also operably coupled to the inverting input of the second amplifier 222 via a second feedback resistor 234. The output of the first amplifier 220 corresponds to the first output 126 of the summing amplifier circuit 110 and the output of the second amplifier 222 corresponds to the second output 128 of the summing amplifier circuit 110. As mentioned above, the outputs of the summing amplifier circuit 110 and hence the outputs of the first and second amplifiers 220, 222 are operably coupled to the first and second inputs 130, 132 of the ADC circuit 134.

It should be appreciated that gain of the summing amplifier 110 allocated for the output of the diagnostic signal circuit 116 in respect of the third and fourth inputs 122, 124 can be lower than the gain of the summing amplifier 110 allocated to amplification of the output of the magnetic sensor 104 in respect of the first and second inputs 112, 114. In this example, about 20% or less of the dynamic range of the summing amplifier 110 is reserved for amplifying the output of the diagnostic signal circuit 116. The relative amounts of dynamic range reserved for the respective outputs of the magnetic sensor 104 and the diagnostic signal circuit 116 can be controlled by appropriate setting of the values of the first, second, third and fourth input resistors 224, 226, 228, 230.

Referring to Figure 4, the signal extraction circuit 136 of Figure 1 comprises a data bus input 300 operably coupled to the first data bus 138. The data bus input 300 serves as an input of a sensor signal processing circuit 302 and an input of a diagnostic signal processing circuit 304. The data bus input 300 is therefore operably coupled to a first shift register of the sensor signal processing circuit 302, the first shift register comprising a first delay unit 306 operably coupled in series to a second delay unit 308, the second delay unit 308 being operably coupled in series to a third delay unit 310. The third delay unit 310 is operably coupled in series to a fourth delay unit 312, the fourth delay unit 312 being operably coupled to a first non-inverting input of a first multiple-input summation circuit 314. A first tap point 316, operably coupled to an output of the first delay unit 306 and an input of the second delay unit 308, is operably coupled to a first inverting input of the first multiple-input summation circuit 314. A second tap point 318, operably coupled to an output of the second delay unit 308 and an input of the third delay unit 310, is operably coupled to a second non-inverting input of the first multiple-input summation circuit 314. A third tap point 320, operably coupled to an output of the third delay unit 310 and an input of the fourth delay unit 312, is operably coupled to a second inverting input of the first multiple-input summation circuit 314. An output of the first multiple-input summation circuit 314 is operably coupled to a fifth delay unit 322. The first, second, third and fourth delay units 306, 308, 310, 312 are coupled to a first source of a clock signal (not shown) operating at the first frequency, $f_1$, and the fifth delay unit 322 is operably coupled to a second source of a clock signal (not shown) operating at one quarter of the first frequency, $f_1/4$. An output of the fifth delay unit 322 is operably coupled to the sensor signal data bus 142.

The data bus input 300 is also operably coupled to a second shift register of the diagnostic signal processing circuit 304 and comprises a sixth delay unit 324 operably coupled in series to a seventh delay unit 326, the seventh delay unit 326 being operably coupled in series to an eighth delay unit 328. The eighth delay unit 328 is operably coupled in series to a ninth delay unit 330, the ninth delay unit 330 being operably coupled to a first non-inverting input of a second multiple-input summation circuit 332. A first tap point 334, operably coupled to an output of the sixth delay unit 324 and an input of the seventh delay unit 326, is operably coupled to a first inverting input of the second multiple-input summation circuit 332. A second tap point 336, operably coupled to an output of the seventh delay unit 326 and an input of the eighth delay unit 328, is operably coupled to a second inverting input of the second multiple-input summation circuit 314. A third tap point 338, operably coupled to an output of the eighth delay unit 328 and an input of the ninth delay unit 330, is operably coupled to a second non-inverting input of the second multiple-input summation circuit 332. An output of the second multiple-input summation circuit 332 is operably coupled to a tenth delay unit 340. The sixth, seventh, eighth and ninth delay units 324, 326, 328, 330 are coupled to the first source of the clock signal (not shown) operating at the first frequency, $f_1$, and the tenth

delay unit 340 is operably coupled to a third source of a clock signal (not shown) operating at one half of the second frequency, $f_2/2$. An output of the fifth delay unit 322 is also operably coupled to the diagnostic signal data bus 143.

Although in this example, shift registers are provided with the number of delay units allocated according to the number of ADC conversions required to be combined in parallel to provide an output, in other examples an accumulation approach can be taken, and ADC conversions can be accumulated as they become available to the signal extraction circuit 136. It should be noted that references above to inverting and non-inverting inputs of the delay units and the multiple-input summation circuits refer to changing the mathematical sign of the data present at the respective inputs of these units/circuits. The delay units described herein are, in this example, stages of respective shift registers, which are digital circuits comprising, for example a cascade of flip-flops, although other constructions are contemplated.

In operation (Figure 5), the sensor output signal processing circuit 102 and the magnetic sensor 104 are initialised (Step 400). The Hall sensor of the magnetic sensor 104 generates a raw detection output signal which varies in the presence of magnetic fields as the Hall sensor responds to the magnetic field. In this example, a conditioning electrical signal at the first frequency, $f_1$, is applied to the signal conditioning circuit 200 in accordance with the known spinning technique as part of a process to remove the presence of a measurement offset that the raw detection output signal generated by the Hall sensor is known to possess, the application of the conditioning electrical signal to the Hall sensor yielding (Step 402) a conditioned analogue sensor signal.

Substantially contemporaneously, the differential DC signal generator 204 of the diagnostic signal circuit 116 generates a differential DC diagnostic output signal that is applied to the chopping circuit 202. An alternating chopping signal at the second frequency, $f_2$, is applied to the chopping circuit 202 and the chopping circuit 202 responsive to the alternating chopping signal alternates the polarity of the differential DC level output signal at the second frequency, $f_2$, in order to yield (Step 404) a modulated analogue diagnostic signal.

Referring to Figure 6, the conditioned analogue sensor signal 500 has a cyclic waveform of a first duration 501 and cycles at the first frequency, $f_1$. The waveform of the conditioned analogue sensor signal 500 transition between two different levels and comprises a rectangular waveform, for example a generally square waveform in this example. With respect to a cycle of the conditioned analogue sensor signal 500, each period of time during which the waveform of the conditioned analogue sensor signal 500 is at either a first DC voltage level 514 or a second DC voltage level 516 corresponds to a pulse duration, hereafter referred to as a sensor signal pulse duration, and each period of time when the waveform of the conditioned analogue sensor signal 500 is either at the first DC voltage 514 or the second DC voltage 516 constitutes a pulse. The sensor signal pulse durations therefore correspond, in this example, to signal level transitions of the conditioned analogue sensor signal 500. In this example, the sensor signal pulse durations are of equal duration, though operational implementations where the duty cycle of the sensor signal varies from 50% are possible. The signal level transitions result, in this example, from the conditioning electrical signal applied in the magnetic sensor 104. Furthermore, sensor signal pulse durations within a cycle of the conditioned analogue sensor signal 500 are contiguous and each sensor signal pulse duration elapses within a predetermined time range within the cycle of the conditioned analogue sensor signal 500.

During a first sensor signal pulse duration 506 (PH0), the conditioned analogue sensor signal 500 is at the second DC voltage level 516, and during a second sensor signal pulse duration 508 (PH1) the conditioned analogue sensor signal 500 is at the first DC voltage level 514. During a third sensor signal pulse duration 510 (PH2), the conditioned analogue sensor signal 500 has returned to the second DC voltage level 516, and during a fourth sensor signal pulse duration 512 (PH3), the conditioned analogue sensor signal 500 has returned to the first DC voltage level 514.

The modulated analogue diagnostic signal 504 has a cyclic waveform and each cycle has a second duration 518. The modulated analogue diagnostic signal 504 cycles at the second frequency, $f_2$, and also alternates between two DC voltage levels. In this example, the waveform of the modulated analogue diagnostic signal 504 transitions between two different levels, namely a third DC voltage level 520 and a fourth DC voltage level 522, and is a generally square in form in this example, although other rectangular waveforms can be employed.

With respect to a cycle of the modulated analogue diagnostic signal 504, each period of time during which the modulated analogue diagnostic signal 504 is at either the third DC voltage level 520 or the fourth DC voltage level 522 corresponds to a pulse duration, hereafter referred to as a diagnostic signal pulse duration, and each period of time when the waveform of the modulated analogue diagnostic signal 504 is either at the third DC voltage or the fourth DC voltage constitutes a pulse. The diagnostic signal pulse durations therefore correspond, in this example, to signal level transitions of the modulated analogue diagnostic signal 504. Furthermore, diagnostic signal pulse durations within a cycle of the modulated analogue diagnostic signal 504 are contiguous and each diagnostic signal pulse duration elapses within a predetermined time range within the cycle of the modulated diagnostic signal 504.

During a first diagnostic signal pulse duration 524 (PD0), the modulated analogue diagnostic signal 504 is at the third DC voltage level 520, and during a second diagnostic signal pulse duration 526 (PD1) the modulated analogue diagnostic signal 504 is at the fourth DC voltage level 522. This pattern is repeated owing to the waveform being cyclic.

Based upon the relative frequencies of the conditioned analogue sensor signal 500 and the modulated analogue diagnostic signal 504, over the first and second diagnostic pulse durations 524, 526, four sensor signal pulse durations "elapse", namely the first, second, third and fourth sensor signal pulse durations 506, 508, 510, 512.

The first duration 501 is shorter than the second duration 518. In this example, the first duration 501 is half the length of the second duration 518. However, it should be appreciated that the second duration 518 is an even numbered multiple of the first duration 501. In this example, the multiple is 2, but other multiples can be employed, for example between about 100 and about 1000, such as 256. Indeed, such higher multiples can be beneficial to prevent the conditioned analogue sensor signal 500 from corrupting demodulation of the modulated analogue diagnostic signal 504. In any event, the frequency of the conditioned analogue sensor signal 500 is greater than the frequency of the modulated analogue diagnostic signal 504. It should also be appreciated that the conditioned analogue sensor signal 500 is substantially phase aligned with the modulated analogue diagnostic signal 504. In this regard, and given the difference in frequencies between the two signals 500, 504, transitions are substantially aligned in time between the two signals 500, 504 within the constraint of the difference in frequencies of these signals 500, 504. By way of further explanation, the two signals 500, 504 can transition at substantially the same time at a first point in time and then not again until the faster of the two signals has cycled enough times (according to the frequency multiplier mentioned above) to transition again at the same time as the slower of the two signals.

The conditioned analogue sensor signal and the modulated analogue diagnostic signal 500, 504 are respectively applied (Steps 406 and 408) to the summing amplifier circuit 110, which amplifies and combines (Step 410) the conditioned analogue sensor signal 500 and the modulated analogue diagnostic signal 504, the mixed and amplified signal (hereinafter the "amplified mixed signal") comprising an amplified conditioned analogue sensor signal level or value, which is an amplified version of the conditioned analogue sensor signal 500 that includes the measurement offset 502 of the Hall sensor. The amplified mixed signal also comprises an amplified modulated analogue diagnostic signal level or value, which is an amplified version of the modulated analogue diagnostic signal 504. The amplified conditioned analogue sensor signal level or value and the amplified modulated analogue diagnostic signal level or value are also subject to an amplification offset introduced by the summing amplifier circuit 110. In this regard, the summing amplifier circuit 110 comprises an inherent voltage offset that results in a bias being introduced into an amplified signal generated by the summing amplifier circuit 110 in the form of the amplification offset mentioned above.

Referring to Figure 7, the amplification and combination of the conditioned analogue sensor signal 500 and the modulated analogue diagnostic signal 504 by the summing amplifier circuit 110 results in the amplified mixed signal 550 being provided at the first and second outputs of the summing amplifier circuit 110, the amplified mixed signal 550 being a differential signal in this example. The amplified mixed signal 550 is the amplified superposition of the amplified conditioned analogue sensor signal and the amplified modulated analogue diagnostic signal, but offset by the measurement offset 502 in amplified form and the amplification offset introduced by the summing amplifier circuit 110. The average amplitude of each cycle of the amplified mixed signal 550 alternates between cycles. This pattern results from the second duration 518 being longer than, for example twice as long as, the first duration 501.

Although in this example the conditioned analogue sensor signal 500 is mixed with the modulated analogue diagnostic signal 504 and amplified by the summing amplifier circuit 110, the skilled person should appreciate that the two signals can be mixed using any other suitable technique, which in some examples does not require contemporaneous amplifications of the signals. Similarly, additional amplification stages can be provided, if required, for example between the summing amplifier circuit 110 and the magnetic sensor 104 and/or between the summing amplifier 110 and the diagnostic signal circuit 116. In this regard, the diagnostic signal circuit 116 can be coupled between amplification stages.

The amplified mixed signal 550 is then digitised (Step 412) by the ADC circuit 134 and a digital output signal comprising a digital representation of the amplified mixed signal 550 is output in the form, in this example, of a serial bitstream to the signal extraction circuit 136, which extracts both a digital representation of the amplified sensor signal 500 (demodulated) substantially absent of the measurement and amplification offsets and a digital representation of the analogue diagnostic signal as amplified also substantially absent of the amplification offset and the amplified measurement offset, which the amplified mixed signal 550 received by the ADC circuit 134 included and so is also present in the digital representation of the amplified mixed signal 550 provided by the ADC circuit 134.

According to the technique for removing the measurement and amplification offsets from a magnetic sensor electrical output signal, where the magnetic sensor electrical output signal is the result of application of the spinning signal, for example a spinning current, mentioned above, the signal levels in respect of different pulse duration sub-periods of the digital output signal are combined in a predetermined manner to eliminate substantially a digital level or value attributable to the modulated analogue diagnostic signal as amplified and digital levels or values attributable to the measurement and amplification offsets from a digital representation of the amplified mixed signal 550 (the digital output signal) to leave a digital level or value of the amplified analogue sensor signal (demodulated) for further processing. In the context of the amplified conditioned analogue sensor signal, the four sensor signal pulse duration sub-periods 506, 508, 510, 512 are used to demodulate and extract in the digital domain the amplified analogue sensor signal without the digital level or value attributable to the modulated analogue diagnostic signal in amplified form and the digital levels or values attributable to the measurement and amplification offsets. In this regard, the following equation is employed:

$$D_{MAG} = D_{PH0} - D_{PH1} + D_{PH2} - D_{PH3} \quad (1)$$

where $D_{PH0}$, $D_{PH1}$, $D_{PH2}$ and $D_{PH3}$ are the signal amplitude levels corresponding to the first, second, third, and fourth sensor signal pulse duration sub-periods 506, 508, 510, 512, and $D_{MAG}$ is the digital representation of the amplified analogue sensor signal (demodulated) without the digital levels or values attributable to the measurement and amplification offsets or the digital level or value attributable to the amplified modulated analogue diagnostic signal. Conveniently, use of two as the multiple between the respective durations of the cycles of the modulated analogue diagnostic signal 504 and the conditioned analogue sensor signal 500 avoids the presence of the digital level or value attributable to the modulated analogue diagnostic signal 504 in amplified form in the digital output signal from corrupting the demodulation of the digital representation of the amplified conditioned analogue sensor signal. As such, by combining the signal levels in respect of the four sensor signal pulse duration sub-periods in accordance with equation (1), the digital levels or values attributable to the measurement and amplification offsets as well as the digital level or value attributable to the amplified modulated analogue diagnostic signal are cancelled out to leave just the analogue sensor signal 500 (demodulated) in amplified and digital form. The removal of the digital level or value attributable to the amplified modulated analogue diagnostic signal arises as a result of the selection of the multiplier for the duration of a cycle of the waveform of the modulated analogue diagnostic signal 504, which also phase aligns transitions of the amplified modulated analogue diagnostic signal with transitions of the amplified conditioned analogue sensor signal as described above.

In relation to Figure 4, the signal extraction circuit 136 is a combination of delay units arranged as shift registers and summation operator circuitry comprising inverting and non-inverting inputs, which together are configured to process discrete temporal portions of a cycle of the waveform of the digital output signal. The signal extraction circuit 136 therefore receives the digital representation of the amplified mixed signal 550 from the ADC circuit 134 in serial form. Each discrete temporal portion of a cycle of the waveform of the digital representation of the amplified mixed signal 550 has substantially the same duration as a pulse of the plurality of pulses of the first cycle of the conditioned analogue sensor signal 500. As the ADC codes are received by the signal extraction circuit 136, the first shift register clocks the ADC codes in respect of the first four pulse duration sub-periods 506, 508, 510, 512 (PH0, PH1, PH2, PH3), which is the faster signal and used as the smallest unit of pulse duration by the first shift register for clocking the pulses of the received digital output signal into the individual delay units 306, 308, 310, 312 of the first shift register. The first, second, third, and fourth pulse duration sub-periods 506, 508, 510, 512 (PH0, PH1, PH2, PH3) correspond to bit units of the digital representation of the amplified conditioned analogue sensor signal for subsequent processing by the sensor signal processing circuit 302. The sensor signal processing circuit 302, and in particular the first, second, third and fourth delay units 306, 308, 310, 312 and the first multiple-input summation unit 314 thereof, are arranged to read in (Step 414) and combine (Step 416) the signal levels provided at the data bus input 300 in accordance with equation (1) above so that the output of the first multiple-input summation unit 314 is a demodulation of the digital representation of the amplified conditioned analogue sensor signal without the digital level or value attributable to the amplified modulated analogue diagnostic signal and without the digital levels or values attributable to the measurement and amplification offsets, which are cancelled out or substantially attenuated at least. The result of the demodulation (sometimes referred to as "de-chopping") is a first code indicative of a magnetic field sensed by the magnetic sensor 104. The result of the demodulation is, in this example, valid on every fourth clock of the first frequency, $f_1$, because the first, second, third and fourth delay units 306, 308, 310, 312 need to be loaded with four ADC conversions owing to the implementations of a four phase Hall sensor spinning technique. As such, the fifth delay unit 322 is clocked on every fourth cycle of the clock signal operating at the first frequency, $f_1$, and so the frequency of the clock signal applied to the fifth delay unit 322 is running at a frequency that is one quarter of the first frequency, $f_1/4$.

In relation to the diagnostic signal, by combining the portions of the waveform of the digitised representation of the amplified mixed signal 550 (the digital output signal) in a different way to that described above in relation to extraction of the sensor signal, it is also possible to demodulate (or de-chop) the amplified modulated analogue diagnostic signal so as to extract a digital representation of the analogue diagnostic signal in amplified form (and demodulated) without the digital levels or values attributable to the measurement and amplification offsets or the digital level or value attributable to the amplified conditioned analogue sensor signal present in the amplified mixed signal 550. In this regard, combining the signal levels of the digitised representation of the amplified mixed signal 550 in respect of the first, second, third, and fourth sensor signal pulse duration sub-periods 506, 508, 510, 512 in the following manner yields the digital representation of the analogue diagnostic signal in amplified form (and demodulated) without the digital levels or values attributable to the measurement and amplification offsets or the digital level or value attributable to the amplified conditioned analogue sensor signal:

$$D_{DIAG} = D_{PH0} + D_{PH1} - D_{PH2} - D_{PH3} \quad (2)$$

where $D_{PH0}$, $D_{PH1}$, $D_{PH2}$ and $D_{PH3}$ are again the signal amplitude levels corresponding to the first, second, third, and fourth sensor signal pulse duration sub-periods 506, 508, 510, 512, and $D_{DIAG}$ is the digital level or value of the analogue diagnostic signal in amplified form without the digital levels or values attributable to the measurement and amplification offsets or the digital level or value attributable to the amplified conditioned analogue sensor signal. By combining the signal levels in respect of the four sensor signal pulse duration sub-periods in accordance with equation (2), the digital levels or values attributable to the measurement and amplification offsets and the digital representation of the amplified conditioned analogue sensor signal are cancelled out to leave just the digital level or value of the analogue diagnostic signal in amplified form, which is of course the demodulated signal.

In relation to Figure 4, the signal extraction circuit 136 receives the digital representation of the amplified mixed signal 550 from the ADC circuit 134 in serial form and the second shift register clocks the ADC codes in respect of the first, second, third, and fourth sensor signal pulse duration sub-phases 506, 508, 510, 512, respectively. The diagnostic signal processing circuit 304, and in particular, the sixth, seventh, eighth and ninth delay units 324, 326, 328, 330 and the second multiple-input summation unit 332 thereof, are arranged to read in (Step 414) and combine (Step 418) the signal levels provided at the data bus input 300 in accordance with equation (2) above so that the output of the second multiple-input summation unit 332 is a demodulation of the digital representation of the amplified modulated analogue diagnostic signal without the digital representation of the amplified conditioned analogue sensor signal and without the digital levels or values attributable to the measurement or amplification offsets, which are cancelled out or substantially attenuated at least. The result of the demodulation (or de-chopping) is a second code representing the analogue diagnostic signal as amplified. The result of the demodulation is, in this example, valid on every second clock of the clock signal at the second frequency, $f_2$, because the sixth, seventh, eighth and ninth delay units 324, 326, 328, 330 need to be loaded with two ADC conversions spanning the four pulse duration sub-periods owing to the implementations of a four phase Hall sensor spinning technique. As such, the tenth delay unit 340 is clocked on every second period of the clock signal of the second frequency, $f_2$, and so the frequency of the clock signal applied to the tenth delay unit 340 is one half of the second frequency, $f_2/2$, or one quarter of the first frequency, $f_1/4$, given the relationship between the first and second frequencies, $f_1$, $f_2$, in this example.

The extracted digital representations of the amplified analogue sensor (demodulated) signal and the analogue diagnostic signal in amplified form, without the measurement and amplification offsets, are then communicated by the signal extraction circuit 136 to the signal analysis circuit 140 via the sensor signal data bus 142 and the diagnostic signal data bus 143, respectively. In this regard, the signal analysis circuit 140 compares the first code corresponding to the extracted digital representation of the amplified analogue sensor signal 500 (demodulated) received from the sensor signal processing circuit 302 with an instance of the first code received previously in order determine a change associated with the magnetic sensor 104, for example a direction of motion. The result of the comparison is provided at the analysis output 144.

The signal analysis circuit 136 is also configured to analyse the digital representation of the analogue diagnostic signal as amplified in order to monitor one or more of: a voltage proportional to a temperature of a die comprising the sensor output processing circuit 102, a reference voltage level used by the ADC circuit 134 to generate the digital output signal, a voltage drop across a diagnostic shunt resistor used in the magnetic sensor 104 to receive the bias current and/or a gain of an amplification path of the amplifier circuit 110. Respective value ranges stored by the signal analysis circuit 136 can be used to determine whether these parameters are within acceptable limits. In this regard, the signal analysis circuit 140 analyses the second code corresponding to the extracted digital representation of the analogue diagnostic signal as amplified received from the diagnostic signal processing circuit 304 in order make one or more of the above described measurements. The results of the monitoring are provided at the analysis output 144 for further processing and/or response. However, the use of the results is not central to an understanding of the examples set forth herein and so for the sake of clarity and conciseness of description, the use of the results will not be described in any further detail.

Although the magnetic sensor 104 in the above examples is described as a Hall sensor, other kinds of sensor arrangement are contemplated, and the above examples should be considered as compatible with such sensor arrangements, for example a pressure sensor and Wheatstone bridge arrangement instead of the magnetic sensor 104. Consequently, any suitable sensor can be used in place of the magnetic sensor 104 with appropriate adjustments to the sensor output signal processing circuit 102.

In the above examples, the time-varying diagnostic signal 504 is a voltage signal. However, it should be understood that the time-varying diagnostic signal 504 can be a current signal with appropriate alterations made to the summing amplifier circuit 110.

## Claims

**1.** A sensor output signal processing circuit apparatus comprising:

a sensor readout circuit configured to receive, when in use, a conditioned analogue sensor signal comprising a measurement offset and having a first cycle of a first duration;

a diagnostic signal circuit comprising an amplitude modulator circuit and a signal generator circuit operably coupled to the amplitude modulator circuit, the signal generator circuit being configured to generate, when in use, an analogue diagnostic signal and the amplitude modulator circuit being configured to modulate the analogue diagnostic signal to provide a modulated analogue diagnostic signal to the sensor readout circuit; and
a signal extraction circuit operably coupled to a digital output of the sensor readout circuit; wherein
the sensor readout circuit is configured to amplify and combine the conditioned analogue sensor signal and the modulated analogue diagnostic signal and to provide at the digital output thereof a digital output signal comprising a digital representation of the combination of the amplified analogue conditioned sensor signal and the amplified modulated analogue diagnostic signal, a digital representation of an amplification offset, and a digital representation of the measurement offset;
the signal extraction circuit is configured to digitally process, when in use, the digital output signal and to provide separately digital demodulated representations of the amplified conditioned analogue sensor signal and the analogue diagnostic signal in amplified form, both without the measurement and amplification offsets; and
the amplitude modulator circuit is configured to alternate polarities of the analogue diagnostic signal so that the modulated analogue diagnostic signal has a second cycle of a second duration where the second duration is an even numbered multiple of the first duration.

2. An apparatus as claimed in Claim 1, wherein the first cycle comprises a plurality of consecutive pulse durations respectively corresponding to a plurality of pulses of the conditioned analogue sensor signal.

3. An apparatus as claimed in Claim 2, wherein the conditioned analogue sensor signal has a rectangular waveform.

4. An apparatus as claimed in Claim 2 or Claim 3, wherein the plurality of pulses respectively result from application, when in use, of a spinning signal to an output signal generated by a magnetic sensor.

5. An apparatus as claimed in any one of the preceding claims, wherein
the sensor readout circuit comprises a summing amplifier circuit operably coupled to an analogue-to-digital converter circuit having the digital output, the summing amplifier circuit being configured to receive, when in use, the conditioned analogue sensor signal.

6. An apparatus as claimed in Claim 5, wherein
an output of the diagnostic signal circuit is operably coupled to an input of the summing amplifier circuit.

7. An apparatus as claimed in any one of the preceding claims, wherein
the signal extraction circuit comprises a first shift register and a first summation circuit operably coupled to the first summation circuit, the signal extraction circuit being configured to process, when in use, discrete temporal portions of a cycle of a waveform of the digital output signal in order to attenuate the amplification and measurement offsets in the digital output signal and provide the demodulated digital representation of the amplified conditioned analogue sensor signal.

8. An apparatus as claimed in any one of Claims 1 to 6, wherein
the signal extraction circuit comprises a second shift register and a second summation circuit operably coupled to the second summation circuit and configured to process, when in use, discrete temporal portions of a cycle of a waveform of the digital output signal in order to attenuate the amplification and measurement offsets in the digital output signal and provide the digital representation of the analogue diagnostic signal in amplified form.

9. An apparatus as claimed in Claim 7 or Claim 8, wherein
each discrete temporal portion of the cycle of the waveform of the digital output signal has substantially the same duration as a pulse of the plurality of pulses of the first cycle of the conditioned analogue sensor signal.

10. An apparatus as claimed in any one of the preceding claims, further comprising:
a signal analysis circuit configured to analyse the digital representation of the analogue diagnostic signal in amplified form in order to monitor one or more of:

a voltage proportional to a temperature of a die comprising the sensor output signal processing circuit;
a reference voltage level used to generate the digital output signal;
a voltage drop across a diagnostic shunt resistor configured to receive a bias current for a Hall sensor; and
a gain of an amplification path of the sensor readout circuit.

**11.** A magnetic field measurement apparatus comprising:

a Hall sensor having a readout output; and
a signal conditioning circuit operably coupled to the Hall sensor; wherein
the readout output of the Hall sensor is operably coupled to an analogue input of the sensor readout circuit of the sensor output signal processing circuit apparatus as claimed in any one of the preceding claims.

**12.** An apparatus as claimed in any one of the preceding claims, wherein the amplitude modulator circuit is a chopping circuit.

**13.** An apparatus as claimed in any one of the preceding claims, wherein

the conditioned analogue sensor signal has a first frequency associated therewith;
the modulated analogue diagnostic signal has a second frequency associated therewith; and
the first frequency is twice the second frequency.

**14.** An apparatus as claimed in any one of Claims 1 to 12, wherein

the conditioned analogue sensor signal has a first frequency associated therewith;
the modulated analogue diagnostic signal has a second frequency associated therewith; and
the first frequency is between 100 to 1000 times faster than the second frequency.

**15.** A method of diagnostic signal generation and extraction, the method comprising:

receiving a conditioned analogue sensor signal comprising a measurement offset and having a first cycle of a first duration;
generating an analogue diagnostic signal and modulating the analogue diagnostic signal to provide a modulated analogue diagnostic signal;
amplifying and combining the conditioned analogue sensor signal and the modulated analogue diagnostic signal;
generating a digital output signal from the combination of the amplified conditioned analogue sensor signal and the amplified modulated diagnostic signal, the digital output signal comprising a digital representation of the combination of the amplified analogue conditioned sensor signal and the amplified modulated analogue diagnostic signal, a digital representation of an amplification offset and a digital representation of the measurement offset; and
digitally processing the digital output signal in order to provide separately demodulated digital representations of the amplified conditioned analogue sensor signal and the analogue diagnostic signal in amplified form, both without the measurement and amplification offsets; wherein
the modulating of the analogue diagnostic signal comprises alternating polarities of the analogue diagnostic signal so that the modulated analogue diagnostic signal has a second cycle of a second duration where the second duration is an even numbered multiple of the first duration.

**Amended claims in accordance with Rule 137(2) EPC.**

**1.** A sensor output signal processing circuit apparatus (102) comprising:

a sensor readout circuit (110, 134) configured to receive, when in use, a conditioned analogue sensor signal (500) comprising a measurement offset and having a first cycle of a first duration (501);
a diagnostic signal circuit (116) comprising an amplitude modulator circuit (116) and a signal generator circuit (204) operably coupled to the amplitude modulator circuit (116), the signal generator circuit (204) being configured to generate, when in use, an analogue diagnostic signal and the amplitude modulator circuit (116) being configured to modulate the analogue diagnostic signal to provide a modulated analogue diagnostic signal (504) to the sensor readout circuit (110, 134); and
a signal extraction circuit (136) operably coupled to a digital output of the sensor readout circuit (110, 134); wherein
the sensor readout circuit (136) is configured to amplify and combine (410) the conditioned analogue sensor signal (500) and the modulated analogue diagnostic signal (504) and to provide at the digital output thereof a digital output signal, the sensor readout circuit (136) comprising an inherent voltage offset and the digital output signal comprising a digital representation of the combination of the amplified analogue conditioned sensor signal and the amplified modulated analogue diagnostic signal (550), a digital representation of an amplification offset introduced into the digital output signal by the inherent voltage offset of the sensor readout circuit (136), and a digital representation of the measurement offset;
the signal extraction circuit (136) is configured to digitally process, when in use, the digital output signal and to provide separately digital demodulated representations of the amplified conditioned analogue sensor signal and the analogue diagnostic signal in amplified form, both without the measurement and amplification offsets; and
the amplitude modulator circuit (116) is configured to alternate polarities of the analogue diagnostic signal so that the modulated analogue diagnostic signal has a second cycle of a second duration (518) where the second duration (518) is an even numbered multiple of the first duration (501).

**2.** An apparatus as claimed in Claim 1, wherein the first cycle comprises a plurality of consecutive pulse durations (506, 508, 520, 512) respectively corresponding to a plurality of pulses of the conditioned analogue sensor signal (500).

**3.** An apparatus as claimed in Claim 2, wherein the conditioned analogue sensor signal (500) has a rectangular waveform.

**4.** An apparatus as claimed in Claim 2 or Claim 3, wherein the plurality of pulses respectively result from application, when in use, of a spinning signal to an output signal generated by a magnetic sensor (104).

**5.** An apparatus as claimed in any one of the preceding claims, wherein
the sensor readout circuit (136) comprises a summing amplifier circuit (110) operably coupled to an analogue-to-digital converter circuit (134) having the digital output, the summing amplifier circuit (110) being configured to receive, when in use, the conditioned analogue sensor signal (500).

**6.** An apparatus as claimed in Claim 5, wherein
an output of the diagnostic signal circuit (116) is operably coupled to an input of the summing amplifier circuit (110).

**7.** An apparatus as claimed in any one of the preceding claims, wherein
the signal extraction circuit (136) comprises a first summation circuit (314) and a first shift register (306, 308, 310, 312) operably coupled to the first summation circuit (314), the signal extraction circuit (136) being configured to process, when in use, discrete temporal portions of a cycle of a waveform of the digital output signal in order to attenuate the amplification and measurement offsets in the digital output signal and provide the demodulated digital representation of the amplified conditioned analogue sensor signal.

**8.** An apparatus as claimed in any one of Claims 1 to 6, wherein
the signal extraction circuit (136) comprises a second summation circuit (332) and a second shift register (324, 326, 328, 330) operably coupled to the second summation circuit (332) and is configured to process, when in use, discrete temporal portions of a cycle of a waveform of the digital output signal in order to attenuate the amplification and measurement offsets in the digital output signal and provide the digital representation of the analogue diagnostic signal in amplified form.

**9.** An apparatus as claimed in Claim 7 or Claim 8, wherein
each discrete temporal portion of the cycle of the waveform of the digital output signal has substantially the same duration as a pulse of the plurality of pulses of the first cycle of the conditioned analogue sensor signal.

**10.** An apparatus as claimed in any one of the preceding claims, further comprising:
a signal analysis circuit (140) configured to analyse the digital representation of the analogue diagnostic signal in amplified form in order to monitor one or more of:

a voltage proportional to a temperature of a die comprising the sensor output signal processing circuit (102);
a reference voltage level used to generate the digital output signal;
a voltage drop across a diagnostic shunt resistor configured to receive a bias current for a Hall sensor (104); and
a gain of an amplification path of the sensor readout circuit (136).

**11.** A magnetic field measurement apparatus comprising:

a Hall sensor (104) having a readout output (106, 108); and
a signal conditioning circuit (200) operably coupled to the Hall sensor; and

a sensor output signal processing circuit apparatus (102) as claimed in any one of the preceding claims; wherein the readout output (106, 108) of the Hall sensor (104) is operably coupled to an analogue input (112, 114) of a sensor readout circuit (110, 134) of the sensor output signal processing circuit apparatus (102).

**12.** An apparatus as claimed in any one of the preceding claims, wherein the amplitude modulator circuit (116) is a chopping circuit.

**13.** An apparatus as claimed in any one of the preceding claims, wherein

the conditioned analogue sensor signal has a first frequency ($f_1$) associated therewith;
the modulated analogue diagnostic signal has a second frequency ($f_2$) associated therewith; and
the first frequency ($f_1$) is twice the second frequency ($f_2$).

**14.** An apparatus as claimed in any one of Claims 1 to 12, wherein

the conditioned analogue sensor signal (500) has a first frequency associated therewith;
the modulated analogue diagnostic signal (504) has a second frequency associated therewith; and
the first frequency is between 100 to 1000 times faster than the second frequency.

**15.** A method of diagnostic signal generation and extraction, the method comprising:

receiving (406) a conditioned analogue sensor signal (500) comprising a measurement offset and having a first cycle of a first duration (501);
generating (404) an analogue diagnostic signal and modulating the analogue diagnostic signal to provide a modulated analogue diagnostic signal (504);
amplifying and combining (410) the conditioned analogue sensor signal (500) and the modulated analogue diagnostic signal (504);
generating (412) a digital output signal from the combination of the amplified conditioned analogue sensor signal and the amplified modulated diagnostic signal, the digital output signal comprising a digital representation of the combination of the amplified analogue conditioned sensor signal and the amplified modulated analogue diagnostic signal (550), a digital representation of an amplification offset introduced into the digital output signal by an inherent voltage offset of a sensor readout circuit (136), and a digital representation of the measurement offset; and
digitally processing (416, 418) the digital output signal in order to provide separately demodulated digital representations of the amplified conditioned analogue sensor signal and the analogue diagnostic signal in amplified form, both without the measurement and amplification offsets; wherein
the modulating of the analogue diagnostic signal comprises alternating polarities of the analogue diagnostic signal so that the modulated analogue diagnostic signal has a second cycle of a second duration (518) where the second duration (518) is an even numbered multiple of the first duration (501).

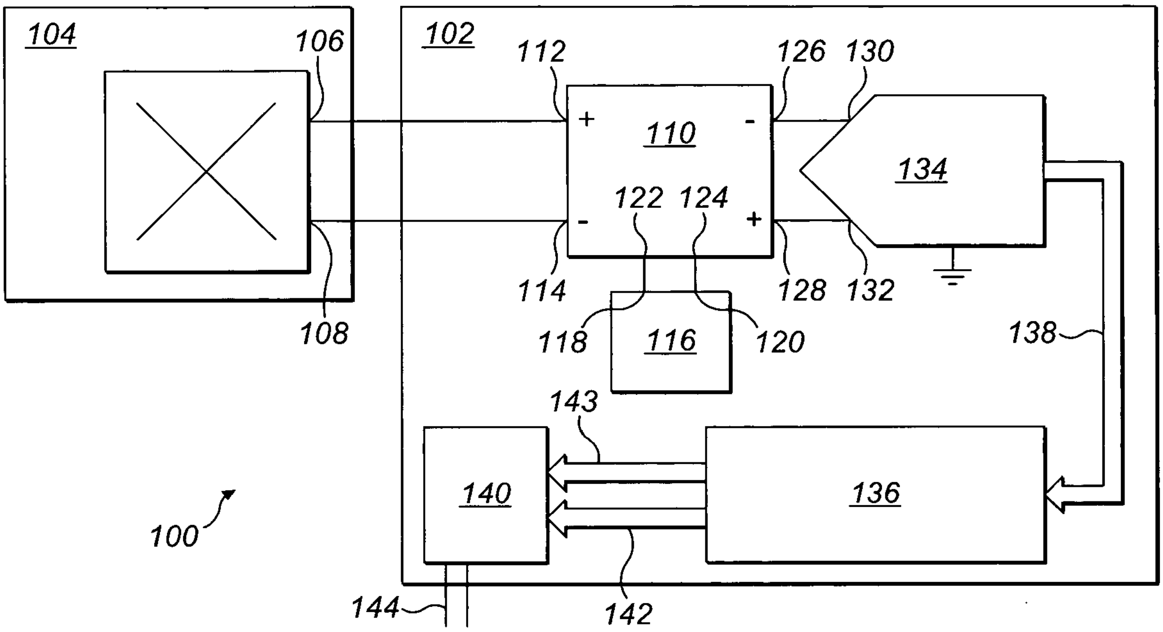
104
106
108
102
112
126
130
110
134
122
124
114
128
132
118
116
120
138
143
140
136
100
144
142

FIG. 1

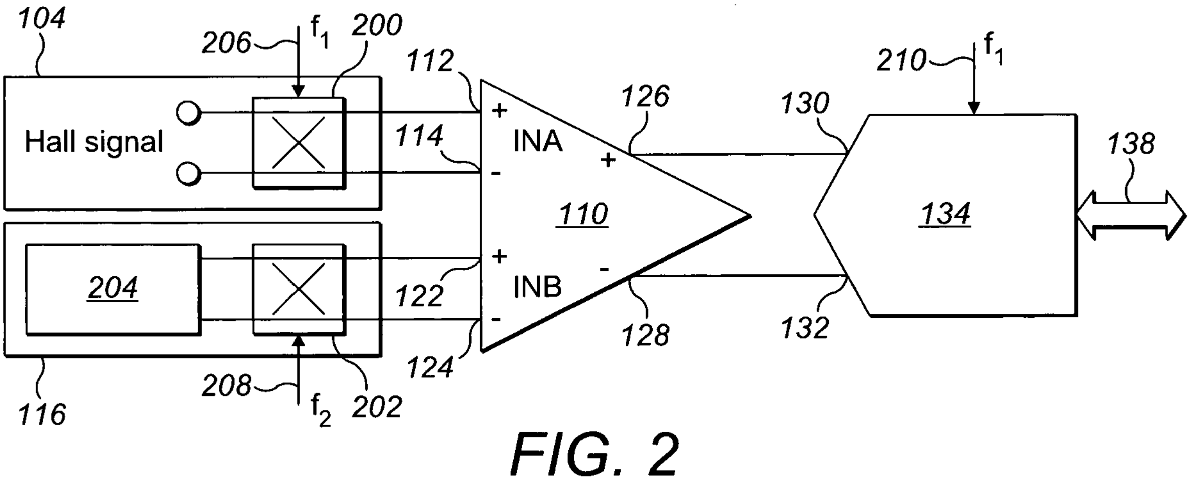
104
206
$f_1$
200
112
126
130
210
$f_1$
Hall signal
114
INA
110
134
138
204
INB
122
128
132
124
208
$f_2$
202
116

FIG. 2

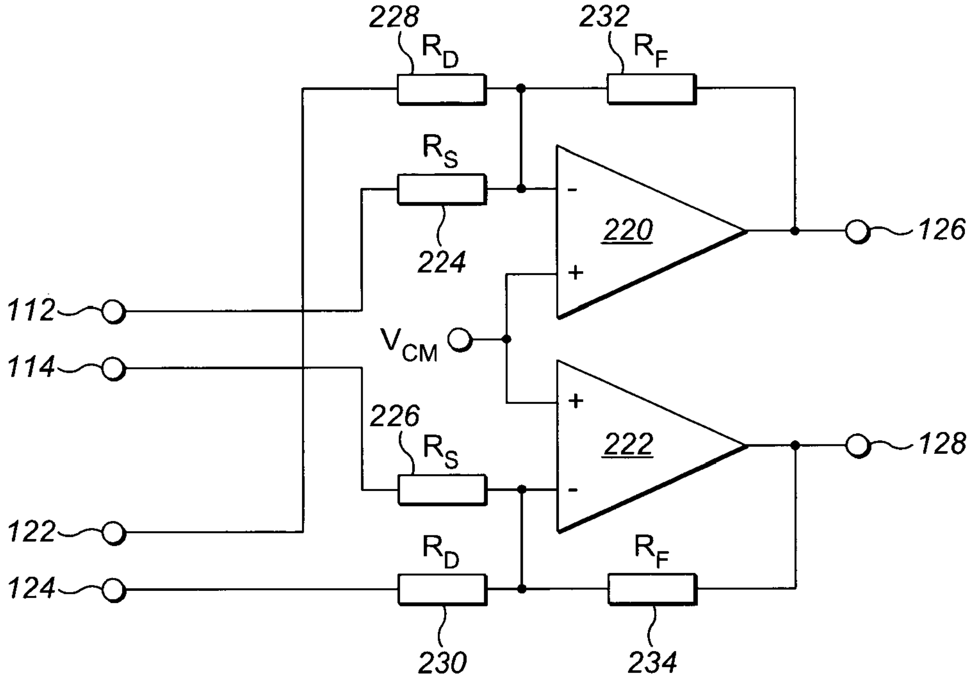
228
$R_D$
232
$R_F$
$R_S$
224
220
126
112
$V_{CM}$
114
226
$R_S$
222
128
122
$R_D$
$R_F$
124
230
234

FIG. 3

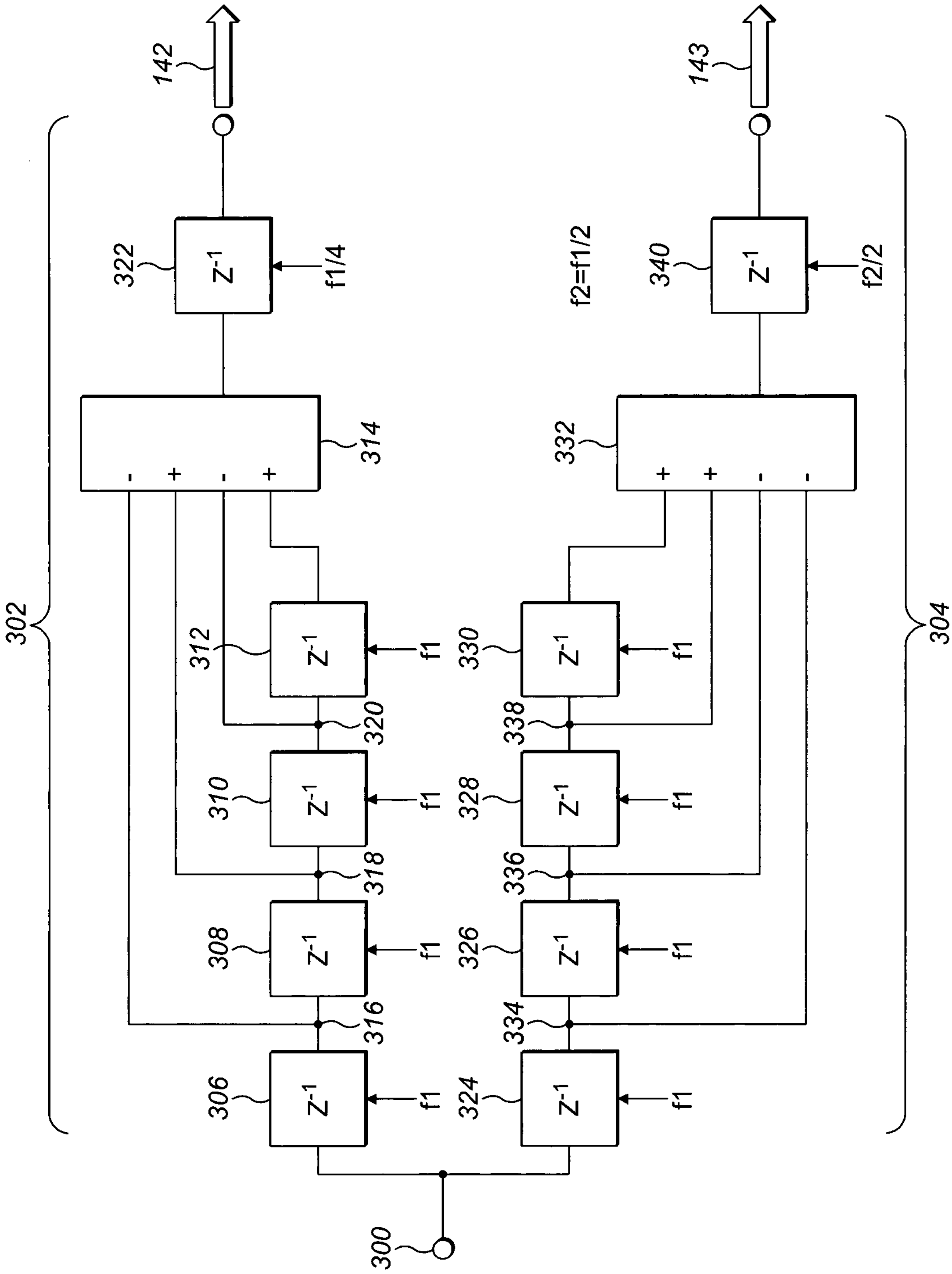
142
143
302
304
300
306
308
310
312
314
316
318
320
322
324
326
328
330
332
334
336
338
340
z-1
f1
f1/4
f2/2
f2=f1/2
+
-

FIG. 4

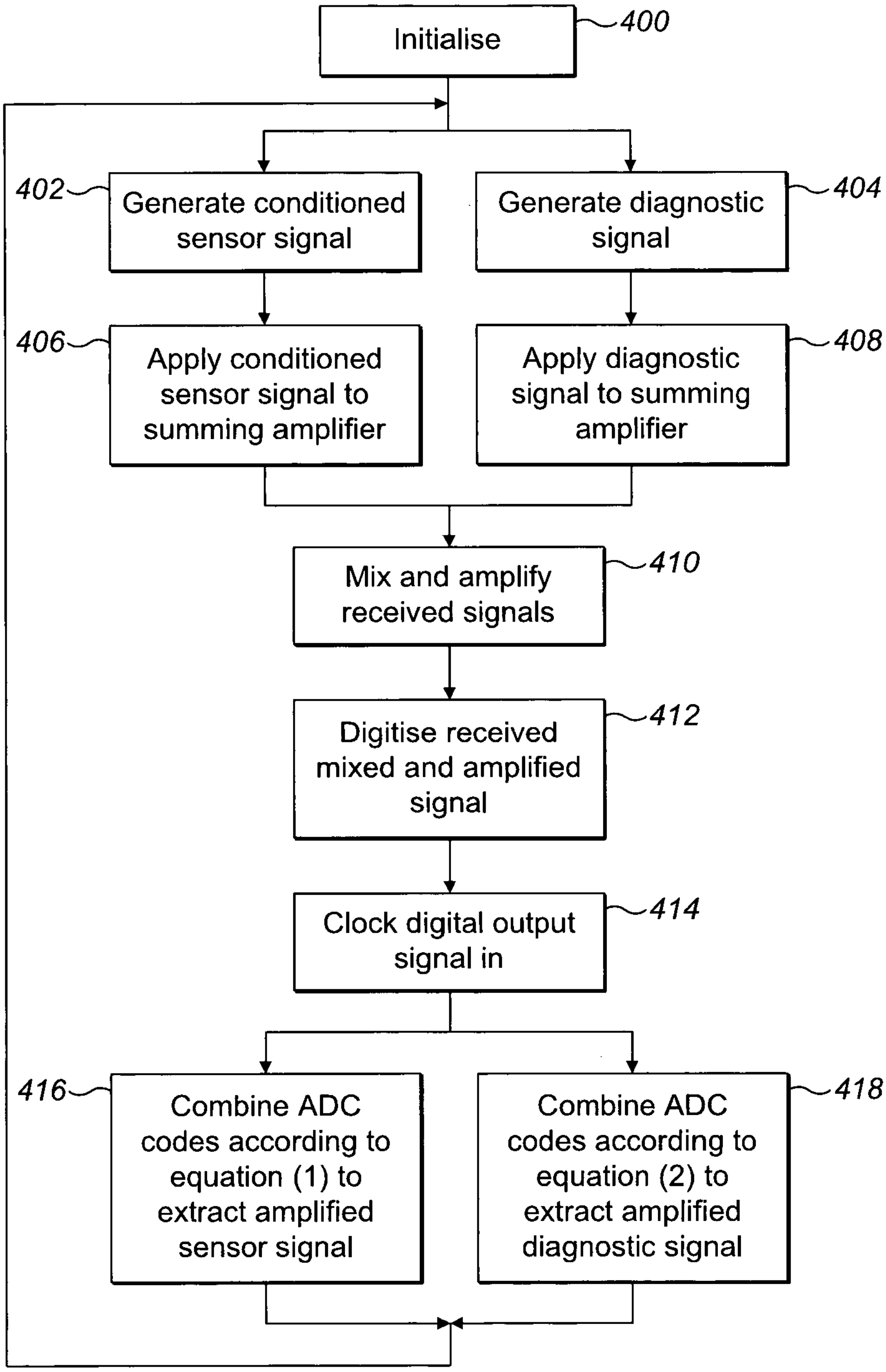
Initialise
400
402
Generate conditioned sensor signal
Generate diagnostic signal
404
406
Apply conditioned sensor signal to summing amplifier
Apply diagnostic signal to summing amplifier
408
Mix and amplify received signals
410
Digitise received mixed and amplified signal
412
Clock digital output signal in
414
416
Combine ADC codes according to equation (1) to extract amplified sensor signal
Combine ADC codes according to equation (2) to extract amplified diagnostic signal
418

FIG. 5

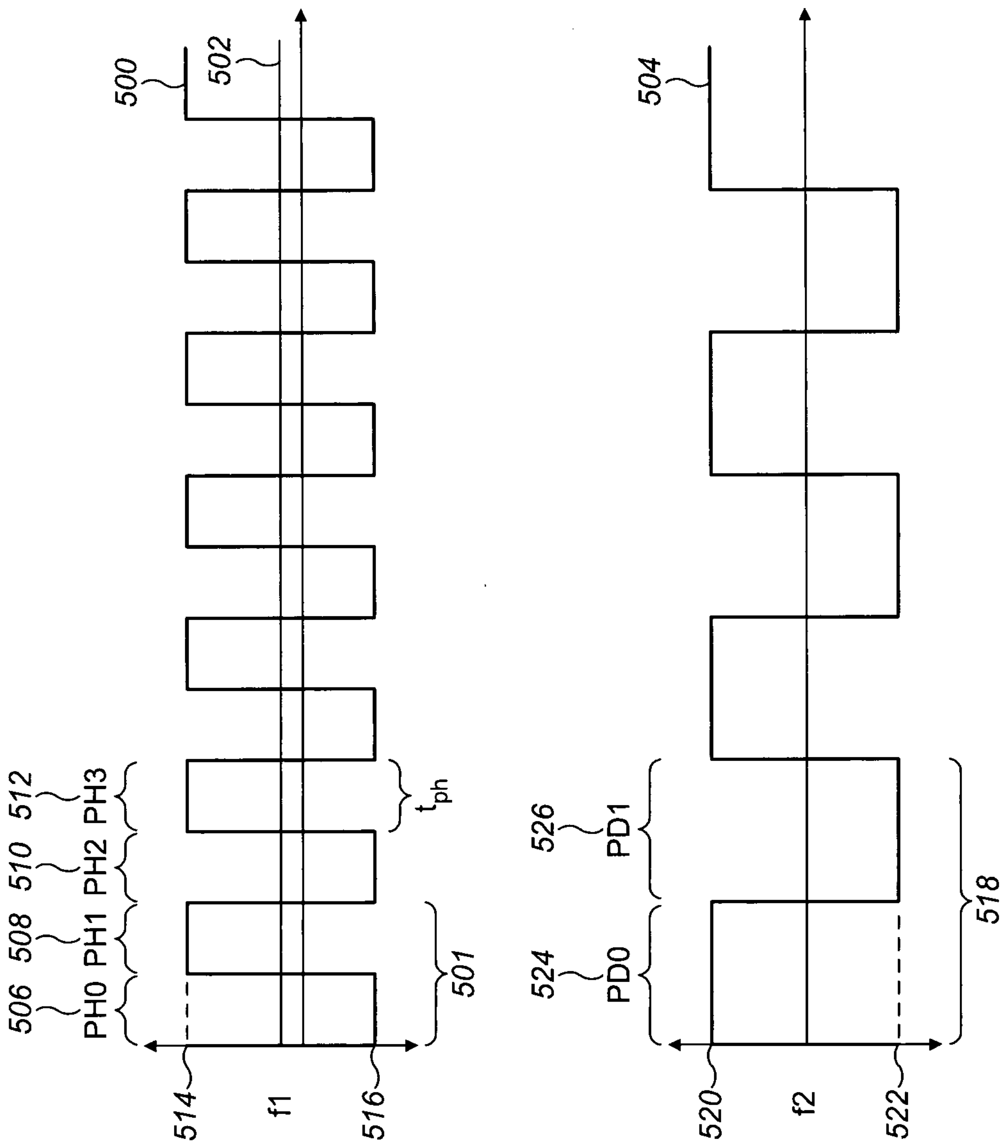
500
502
501
506
PH0
508
PH1
510
PH2
512
PH3
$t_{ph}$
514
f1
516
504
518
520
f2
522
524
PD0
526
PD1

FIG. 6

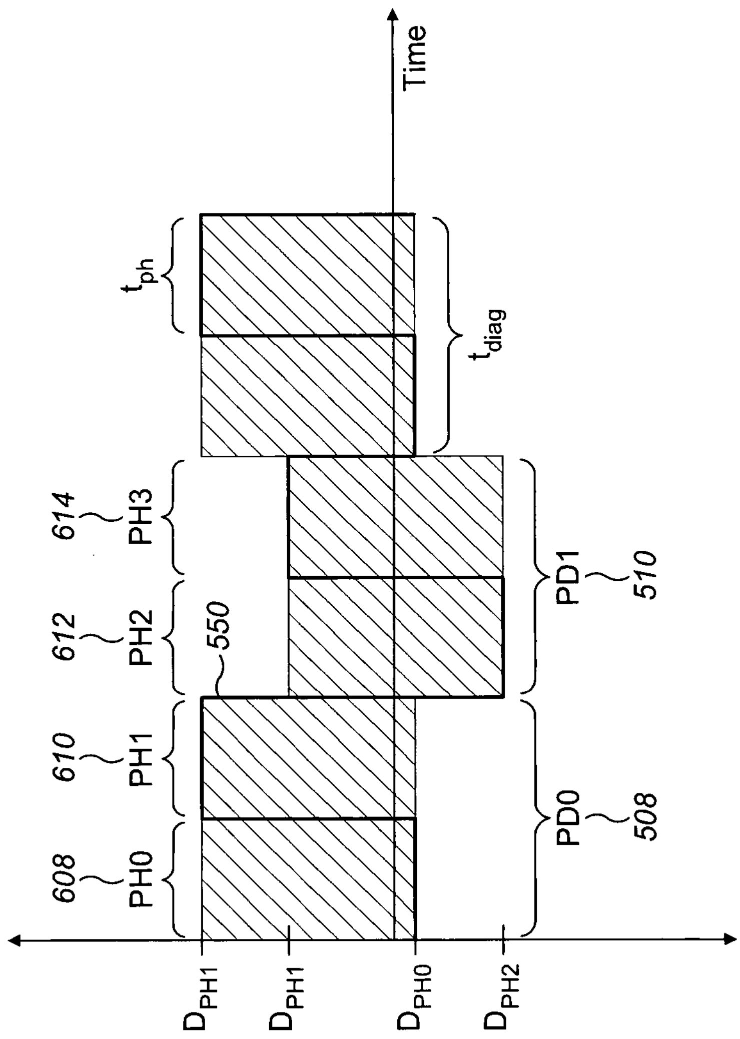


FIG. 7

Konstantin Nedelchev Tahtadjiev
Digitally signed by Konstantin Nedelchev Tahtadjiev
Date: 2024.12.27 14:01:35 +02'00'

Europäisches Patentamt
European Patent Office
Office européen des brevets

# EUROPEAN SEARCH REPORT

Application Number
EP 24 47 2020

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2024/192028 A1 (VAN WEGBERG ROLAND [NL]) 13 June 2024 (2024-06-13)<br>* paragraph [0014] *<br>* paragraph [0046] - paragraph [0053]; figure 1 *<br>* paragraphs [0056], [0058] *<br>----- | 1-15 | INV.<br>G01R33/00<br>G01D3/036 |
| A | AHMAD MERAJ ET AL: "An Auto-Calibrated Resistive Measurement System With Low Noise Instrumentation ASIC",<br>IEEE JOURNAL OF SOLID-STATE CIRCUITS, IEEE, USA,<br>vol. 55, no. 11,<br>1 November 2020 (2020-11-01), pages 3036-3050, XP011816043,<br>ISSN: 0018-9200, DOI: 10.1109/JSSC.2020.3017639<br>[retrieved on 2020-10-22]<br>* abstract *<br>* page 3040, right-hand column, paragraph 3 - page 3041, left-hand column, paragraph 1; figure 4(c) *<br>* page 3041, right-hand column, paragraph 2 *<br>----- | 1-15 | |
| X | US 2016/252599 A1 (MOTZ MARIO [AT] ET AL) 1 September 2016 (2016-09-01)<br>* paragraph [0030] - paragraph [0034]; figure 2 *<br>* paragraph [0037] - paragraph [0041]; figure 3 *<br>----- | 11 | TECHNICAL FIELDS SEARCHED (IPC)<br>G01D<br>G01R<br>H03F |

The present search report has been drawn up for all claims

| Place of search | Date of completion of the search | Examiner |
|---|---|---|
| Munich | 5 June 2025 | Jakob, Clemens |

2

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

## ANNEX TO THE EUROPEAN SEARCH REPORT ON EUROPEAN PATENT APPLICATION NO. EP 24 47 2020

This annex lists the patent family members relating to the patent documents cited in the above-mentioned European search report. The members are as contained in the European Patent Office EDP file on
The European Patent Office is in no way liable for these particulars which are merely given for the purpose of information.

05-06-2025

| Patent document cited in search report | Publication date | Patent family member(s) | Publication date |
|---|---|---|---|
| US 2024192028 A1 | 13-06-2024 | EP 4382869 A1 | 12-06-2024 |
| | | US 2024192028 A1 | 13-06-2024 |
| US 2016252599 A1 | 01-09-2016 | CN 105929343 A | 07-09-2016 |
| | | DE 102015102853 A1 | 01-09-2016 |
| | | US 2016252599 A1 | 01-09-2016 |
| | | US 2020011955 A1 | 09-01-2020 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 0118556 A1
- EP 0548391 A1
- DE 4302342 A1